# EUROPEAN PATENT APPLICATION

(11) **EP 2 996 166 A1**
(43) Date of publication of application: **16.03.2016**
(21) Application number: 15157961.2
(22) Date of filing: 06.03.2015
(51) Int. Cl.: H01L 33/50, H01L 25/075

(54) **Semiconductor light-emitting device**

(30) Priority: 12.09.2014 JP 2014186661
(71) Applicant: Kabushiki Kaisha Toshiba, Tokyo 105-8001 (JP)
(72) Inventor: Akimoto, Yosuke, Tokyo, 105-8001 (JP); Kojima, Akihiro, Tokyo, 105-8001 (JP); Shimada, Miyoko, Tokyo, 105-8001 (JP); Tomizawa, Hideyuki, Tokyo, 105-8001 (JP); Sugizaki, Yoshiaki, Tokyo, 105-8001 (JP); Furuyama, Hideto, Tokyo, 105-8001 (JP)
(74) Representative: Hoffmann Eitle

(57) **Abstract**

A semiconductor light-emitting device includes a light-emitting element (10) including a light-emitting layer (13); a first transparent resin (31) provided on the light-emitting element (10); a second transparent resin (32); and a phosphor (33) scattered in a transparent resin (31, 32) and emitting a light of a different wavelength from a radiated light of the light-emitting layer (13); and wherein one transparent resin (31,32) surrounds at least a portion of the other (32,31).
The frequency of excitation of the phosphor (33) particles provided the furthest away from the light-emitting layer (13), and the extraction of light converted by the phosphor (33) particles provided the closest to the light-emitting layer (13), can be increased by light travelling through the one of the first and second transparent resin (31,32) not including the phosphor (33).

## Description

### FIELD

Embodiments described herein relate generally to a semiconductor light-emitting device.

### BACKGROUND

A semiconductor light-emitting device having a chip-sized package structure has been proposed as a semiconductor light-emitting device which radiates visible light such as white light or light beams having other wavelength zones by combining a semiconductor light-emitting element and a phosphor.

### BRIEF DESCRIPTION OF THE DRAWINGS

FIG. 1 is a schematic cross-sectional view of a semiconductor light-emitting device of an embodiment;
FIG. 2A is a schematic plan view of the semiconductor light-emitting device of the embodiment and FIG. 2B is a schematic cross-sectional view of a part of the semiconductor light-emitting device of the embodiment;
FIG. 3A is a schematic plan view of the semiconductor light-emitting device of the first embodiment and FIG. 3B is a schematic cross-sectional view of the semiconductor light-emitting device of the first embodiment;
FIG. 4A is a schematic plan view of the semiconductor light-emitting device of the first embodiment and FIG. 4B is a schematic cross-sectional view of the semiconductor light-emitting device of the first embodiment;
FIG. 5A and FIG. 5B are schematic cross-sectional views of the semiconductor light-emitting device of the first embodiment;
FIG. 6 is a schematic plan view of the semiconductor light-emitting device of the first embodiment;
FIG. 7A is a schematic plan view of the semiconductor light-emitting device of the second embodiment and FIG. 7B is a schematic cross-sectional view of the semiconductor light-emitting device of the first embodiment;
FIG. 8A is a schematic plan view of the semiconductor light-emitting device of the second embodiment and FIG. 8B is a schematic cross-sectional view of the semiconductor light-emitting device of the first embodiment;
FIG. 9A is a schematic plan view of the semiconductor light-emitting device of the second embodiment and FIG. 9B is a schematic cross-sectional view of the semiconductor light-emitting device of the first embodiment;
FIG. 10 is a schematic cross-sectional view of the semiconductor light-emitting device of the first embodiment;
FIG. 11A is a schematic plan view of the semiconductor light-emitting device of the second embodiment and FIG. 11B is a schematic cross-sectional view of the semiconductor light-emitting device of the first embodiment;
FIG. 12 is a schematic cross-sectional view of the semiconductor light-emitting device of the second embodiment;
FIG. 13A and FIG. 13B are schematic cross-sectional views of the semiconductor light-emitting device of the first embodiment;
FIG. 14A and FIG. 14B are schematic cross-sectional views showing a method for manufacturing the semiconductor light-emitting device of the second embodiment;
FIG. 15A is a schematic plan view of the semiconductor light-emitting device of the third embodiment and FIG. 15B is a schematic cross-sectional view of the semiconductor light-emitting device of the third embodiment;
FIG. 16 is a schematic plan view of the semiconductor light-emitting device of the third embodiment; and
FIG. 17A and FIG. 17B are schematic cross-sectional views of the phosphor.

### DETAILED DESCRIPTION

According to one embodiment, a semiconductor light-emitting device includes a light-emitting element including a light-emitting layer; a first transparent body provided on the light-emitting element; a phosphor scattered in the first transparent body and emitting a light of a different wavelength from a radiated light of the light-emitting layer; and a second transparent body including a first transparent portion and a second transparent portion. The first transparent portion is surrounded by the first transparent body in an area on the light-emitting element. The second transparent portion is provided on the first transparent body and the first transparent portion. The second transparent portion includes an inclined portion provided on the first transparent portion. The inclined portion is inclined with respect to a first direction orthogonal to the light-emitting layer.

Hereinafter, the description is given of an embodiment with reference to the drawings. Like reference numerals are given to portions like those in the drawings.

### (First embodiment)

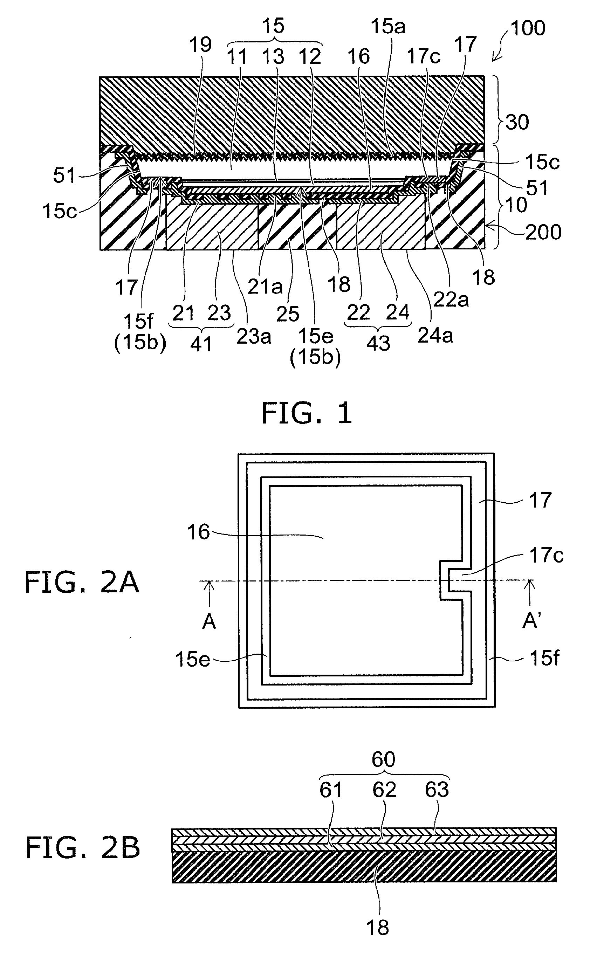

FIG. 1 is a cross-sectional view schematically illustrating a semiconductor light-emitting device of an embodiment.
FIG. 2A is a plan view schematically illustrating an example of a planar layout of a p-side electrode 16 and an n-side electrode 17 in the semiconductor light-emitting device of the embodiment.
FIG. 1 corresponds to a cross section taken along line A-A' in FIG. 2A.

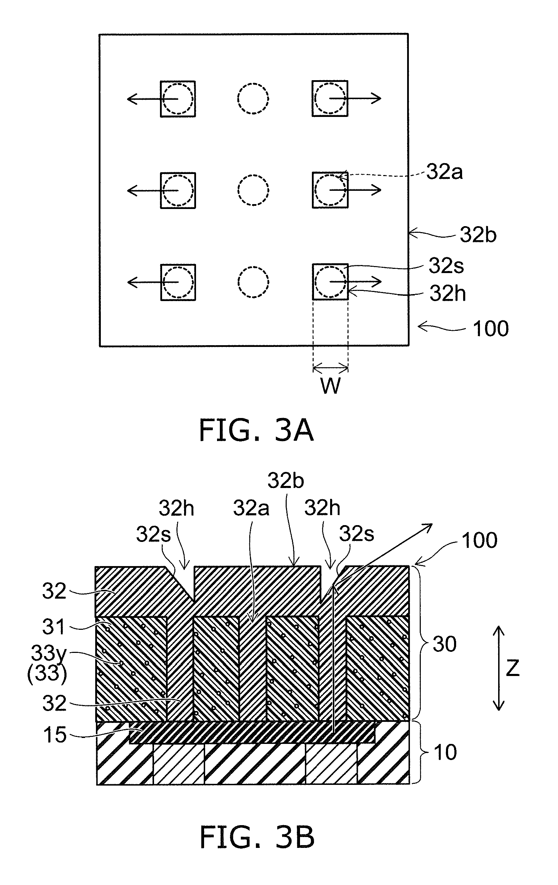

FIG. 3A is a top view schematically illustrating the semiconductor light-emitting device of the first embodiment and FIG. 3B is a cross-sectional view schematically illustrating the semiconductor light-emitting device of the first embodiment.
FIG. 3B illustrates a simplified schematic of a light-emitting element 10 as shown in FIG. 1.
FIG. 1 illustrates a simplified schematic of an optical layer 30 as shown in FIG. 3B.

A semiconductor light-emitting device 100 of the first embodiment includes the light-emitting element 10 and the optical layer 30. The light-emitting element 10 includes a semiconductor layer 15 including a light-emitting layer 13. The semiconductor layer 15 includes a first surface 15a and a second surface 15b on the opposite side of the first surface 15a.

The second surface 15b of the semiconductor layer 15 includes a portion 15e (a light-emitting area) including the light-emitting layer 13 and a portion 15f not including the light-emitting layer 13. The portion 15e including the light-emitting layer 13 is a portion of the semiconductor layer 15 in which the light-emitting layer 13 is provided. The portion 15f not including the light-emitting layer 13 is a portion of the semiconductor layer 15 in which the light-emitting layers 13 is not provided. The portion 15e including the light-emitting layer 13 is an area having a stacked structure which is capable of extracting light emitted from the light-emitting layer 13 to the outside.

In the second surface 15b, the p-side electrode 16 is provided on the portion 15e including the light-emitting layer 13, and the n-side electrode 17 is provided on the portion 15f not including the light-emitting layer 13.

In an example illustrated in FIG. 2A, the portion 15f not including the light-emitting layer 13 surrounds the portion 15e including the light-emitting layer 13 and the n-side electrode 17 surrounds the p-side electrode 16.

An electrical current is supplied to the light-emitting layer 13 via the p-side electrode 16 and the n-side electrode 17 such that the light-emitting layer 13 emits light. Then, the light radiated from the light-emitting layer 13 is radiated to the outside of the semiconductor light-emitting device 100 from the first surface 15a side.

As shown in FIG. 1, a support 200 is provided on the second surface 15b side of the semiconductor layer 15. The light-emitting element including the semiconductor layer 15, the p-side electrode 16, and the n-side electrode 17 is supported by the support 200 provided on the second surface 15b side.

The optical layer 30 is provided on the first surface 15a side of the semiconductor layer 15 as a layer in which a desired optical property is imparted to the light radiated from the semiconductor layer 15. The optical layer 30 includes a plurality of particulate phosphors 33. The phosphor 33 is excited by the light radiated from of the light-emitting layer 13 and emits light having a wavelength which is different from the emitted light.

The phosphors 33 are, for example, scattered in a first transparent resin 31 (a first layer). The first transparent resin 31 transmits the light radiated from the light-emitting layer 13 and the light radiated from the phosphor 33. Thus, the first transparent resin 31 has transparency. Here, the expression "transmit" is not limited to be 100% of transmittance but includes a case where a portion of light is absorbed. Note that as the first transparent resin 31, a transparent material, for example, glass or the like may be used.

The semiconductor layer 15 includes a first semiconductor layer 11, a second semiconductor layer 12, and the light-emitting layer 13. The light-emitting layer 13 is provided between the first semiconductor layer 11 and the second semiconductor layer 12. The first semiconductor layer 11 and the second semiconductor layer 12 include, for example, gallium nitride.

The first semiconductor layer 11 includes, for example, a foundation buffer layer and an n-type GaN layer. The second semiconductor layer 12 includes, for example, a p-type GaN layer. The light-emitting layer 13 includes a material which emits blue light, violet light, bluish purple light, UV light, or the like. The emission peak wavelength of the light-emitting layer 13 may be, for example, 360 nm to 470 nm and an emission peak wavelength of 430 nm to 470 nm is preferable.
The second surface 15b of the semiconductor layer 15 is processed into an uneven shape. A protrusion portion thereof is the portion 15e including the light-emitting layer 13 and a recess portion thereof is the portion 15f not including the light-emitting layer 13. A surface of the portion 15e including the light-emitting layer 13 is a surface of the second semiconductor layer 12 and the p-side electrode 16 is provided on the surface of the second semiconductor layer 12. A surface of the portion 15f not including the light-emitting layer 13 is a surface of the first semiconductor layer 11 and the n-side electrode 17 is provided on the surface of the first semiconductor layer 11.

In the second surface of the semiconductor layer 15, an area of the portion 15e including the light-emitting layer 13 is wider than an area of the portion 15f not including the light-emitting layer 13. In addition, an area of the p-side electrode 16 which is provided on the surface of the portion 15e including the light-emitting layer 13 is wider than an area of the n-side electrode 17 which is provided on the surface of the portion 15f not including the light-emitting layer 13. Accordingly, the wider light-emitting surface can be obtained and the optical output can become higher.

As shown in FIG. 2A, the n-side electrode 17 includes, for example, four linear portions and a contact portion 17c, projecting in the width direction of the linear portion, and is provided on one linear portion among the four linear portions. A via hole 22a of an n-side wire layer 22 is connected to the surface of the contact portion 17c as shown in FIG. 1.

The second surface 15b of the semiconductor layer 15, the p-side electrode 16 and, the n-side electrode 17 are covered with an insulating film 18 as shown in FIG. 1. The insulating film 18 is, for example, an inorganic insulating film such as a silicon oxide film. The insulating film 18 is also provided on the side surface of the light-emitting layer 13 and the side surface of the second semiconductor layer 12 so as to cover the side surfaces.

In addition, the insulating film 18 is also provided on a side surface (the side surface of the first semiconductor layer 11) 15c continuing from the first surface 15a in the semiconductor layer 15 so as to cover the side surface 15c.

Further, the insulating film 18 is also provided in an outer peripheral portion of a chip surrounding the side surface 15c of the semiconductor layer 15. The insulating film 18 which is provided in the outer peripheral portion of the chip extends in a direction far from the side surface 15c on the first surface 15a side.

A p-side wire layer 21 and the n-side wire layer 22 which are separated from each other are provided on the insulating film 18 of the second surface side. A plurality of first openings which lead to the p-side electrode 16 and a second opening which leads to the contact portion 17c of the n-side electrode 17 are formed in the insulating film 18. Meanwhile, the first openings may be one large opening.

The p-side wire layer 21 is provided on the insulating film 18 and is provided inside the first opening. The p-side wire layer 21 is electrically connected to the p-side electrode 16 via a via hole 21a provided inside the first opening.

The n-side wire layer 22 is provided on the insulating film 18 and is provided inside the second opening. The n-side wire layer 22 is electrically connected to the contact portion 17c of the n-side electrode 17 via the via hole 22a provided inside the second opening.

The p-side wire layer 21 and the n-side wire layer 22 occupy a large portion in the area of the second surface side and extend over the insulating film 18. The p-side wire layer 21 is connected to the p-side electrode 16 via a plurality of via holes 21a.

In addition, a reflecting film 51 covers the side surface 15c of the semiconductor layer 15 via the insulating film 18. The reflecting film 51 does not come in contact with the side surface 15c and is not electrically connected to the semiconductor layer 15. The reflecting film 51 is separated from the p-side wire layer 21 and the n-side wire layer 22. The reflecting film 51 has the reflectance with respect to the radiated light from the light emitting layer 13 and the radiated light from the phosphor 31.

The reflecting film 51, the p-side wire layer 21, and the n-side wire layer 22 include, for example, a copper film which is concurrently formed on a common portion of a metallic film 60 as shown in FIG. 2B by means of, for example, an electroplating method.

Such a copper film configuring the reflection film 51, the p-side wire layer 21, and the n-side wire layer 22 is formed on the metallic film 60 which is formed on the insulating film 18 by means of the electroplating method. The thickness of each of the reflection film 51, the p-side wire layer 21, and the n-side wire layer 22 is greater than the thickness of the metallic film 60.

The metallic film 60 includes a foundation metallic film 61, an adhesion layer 62, and a seed layer 63 which are stacked in order from the insulating film 18 side.

The foundation metallic film 61 which has the high reflectance with respect to the radiated light from the light emitting layer 13 is, for example, an aluminum film.

The seed layer 63 is a copper film for educing copper through the electroplating method. The adhesion layer 62 is, for example, a titanium film which is excellent in wettability with respect to both the aluminum and the copper.

Meanwhile, in the outer peripheral portion of the chip adjacent to the side surface 15c of the semiconductor layer 15, the reflecting film 51 may be formed of the metallic film 60 without forming a plated film (the copper film) on the metallic film 60. The reflecting film 51 includes the aluminum film 61 at least, and thus has the high reflectance with respect to the radiated light of the light emitting layer 13 and the radiated light of the phosphor 31.

In addition, since the foundation metallic film (an aluminum film) 61 remains below the p-side wire layer 21 and the n-side wire layer 22, the aluminum film 61 is formed to extend over the large portion in the area of the second surface side. For this reason, it is possible to increase an amount of the light directed to the optical layer 30 side.

A p-side metal pillar 23 is provided on the surface in the p-side wire layer 21 which is on the opposite side of the semiconductor layer 15. A p-side wire portion 41 is formed of the p-side wire layer 21 and the p-side metal pillar 23.

An n-side metal pillar 24 is provided on the surface in the n-side wire layer 22 which is on the opposite side of the semiconductor layer 15. An n-side wire portion 43 is formed of the n-side wire layer 22 and the n-side metal pillar 24.

A resin layer 25 is provided between the p-side wire portion 41 and the n-side wire portion 43 as a second insulating film. The resin layer 25 is provided between the p-side metal pillar 23 and the n-side metal pillar 24 so as to come in contact with the side surface of the p-side metal pillar 23 and the side surface of the n-side metal pillar 24. In other words, a space between the p-side metal pillar 23 and the n-side metal pillar 24 is filled with the resin layer 25.

In addition, the resin layer 25 is provided between the p-side wire layer 21 and the n-side wire layer 22, between the p-side wire layer 21 and the reflecting film 51, and between the n-side wire layer 22 and the reflecting film 51.

The resin layer 25 is provided in the periphery of the p-side metal pillar 23 and the periphery of the n-side metal pillar 24 so as to cover the side surface of the p-side metal pillar 23 and the side surface of the n-side metal pillar 24.

Further, the resin layer 25 is also provided in the outer peripheral portion of the chip which is adjacent to the side surface 15c of the semiconductor layer 15 so as to cover the reflecting film 51.

An end portion (surface) which is on the opposite side of the p-side wire layer 21 in the p-side metal pillar 23 is exposed from the resin layer 25 and functions as a p-side external terminal 23a capable of being connected to the outside circuit such as a mounting substrate. An end portion (surface) which is on the opposite side of the n-side wire layer 22 in the n-side metal pillar 24 is exposed from the resin layer 25 and functions as an n-side external terminal 24a capable of being connected to the outside circuit such as a mounting substrate. The p-side external terminal 23a and the n-side external terminal 24a are bonded to land patterns of the mounting substrate via, for example, a solder or a conductive bonding material.

As shown in FIG. 3A and FIG 3B, the first transparent resin 31 (the layer), a second transparent resin 32 (a second layer) and the phosphor 33 are provided as the optical layer 30. The second transparent resin 32 includes a first transparent portion 32a (a first portion), a second transparent portion 32b (a second portion), and an inclined portion 32s. The first transparent portion 32a and the second transparent portion 32b have transparency.

The first transparent portion 32a is surrounded by the first transparent resin 31. The first transparent portion 32a is formed, for example, in a pillar shape of which a diameter is several µm to several tens of µm and at a size that is enough for visible light to pass therethrough. The first transparent portion 32a is, for example, disposed at an equal interval as shown in FIG. 3A when viewed in the direction from the optical layer 30 to the light-emitting element 10. The first transparent portion 32a may be formed, for example, in an elliptic pillar shape.

The first transparent portion 32a passes through the first transparent resin 31. Alternatively, the first transparent portion 32a may not pass through the first transparent resin 31.

The phosphors 33 are scattered in the first transparent resin 31. In contrast, the phosphor 33 is not provided in the second transparent resin 32.

Similar to the first transparent resin 31, the second transparent resin 32 transmits the light radiated from the light-emitting layer 13 and the light radiated from the phosphor 33. A material of the second transparent resin 32 may be the same material as that of the first transparent resin 31 or may be a different material from that of the first transparent resin 31.

The phosphor 33 is excited by a portion of the light radiated to the first transparent resin 31 from the semiconductor layer 15 including the light-emitting layer 13. Thus, the wavelength of the light emitted from the phosphor 33 is greater than the wavelength of the light radiated from the semiconductor layer 15. That is, the phosphor 33 emits the light of a wavelength which is different from that of the light radiated from the light-emitting layer 13. For that reason, when the phosphor 33 absorbs blue light, the color of the light radiated from the phosphor 33 (33y) is, for example, yellow.

The first transparent portion 32a formed in the pillar shape of the second transparent resin 32 is disposed on an area overlapping with the semiconductor layer 15. Accordingly, the light radiated from the semiconductor layer 15 contains a component radiated to the outside from the upper surface of the optical layer 30 via the first transparent portion 32a. The color of the light is the same as that of the light radiated from the semiconductor layer 15 (the light-emitting layer 13), for example, the blue light is radiated.

The second transparent portion 32b is provided on the first transparent resin 31 and on the first transparent portion 32a. The second transparent portion 32b is integrally provided with the first transparent portion 32a.

The second transparent portion 32b includes the inclined portion 32s which is inclined with respect to a first direction Z perpendicular to the light-emitting layer 13 and inclined with respect to the first surface 15a of the semiconductor layer 15. The inclined portion 32s is provided on the first transparent portion 32a.

As shown in FIG. 3B, the inclined portion 32s is provided, for example, in a void 32h which is formed in the second transparent portion 32b. As shown in FIG. 3A, a width W of the inclined portion 32s in a second direction parallel with the light-emitting layer 13 is larger than the diameter of the first transparent portion 32a. Thus, when it comes to forming the inclined portion 32s, even if a deviation occurs when positioning is performed with respect to the first transparent portion 32a, the inclined portion 32s is not formed by being deviated from the upper surface of the first transparent portion 32a. The inclined portion 32s is formed in the second transparent portion 32b by means of, for example, an imprinting method using a template.

The inside of the void 32h is, for example, hollow. In the inside of the void 32h, a material having a refractive index lower than that of the second transparent resin 32 may be provided, for example.

The depth of the void 32h becomes greater toward the center portion side from the side surface side of the optical layer 30. The upper end of the inclined portion 32s is positioned at the side surface side of the optical layer 30 from the lower end of the inclined portion 32s. Therefore, it is possible to cause the light which is radiated from the semiconductor layer 15 and travels the inside of the first transparent portion 32a in the first direction (in the direction Z) to be totally reflected from the inclined portion 32s to the side surface side of the optical layer 30.

In the structure in which the phosphor layer is provided on the semiconductor layer including the light-emitting layer, generally, the excitation light (for example, the blue light) from the light-emitting layer is more absorbed by the phosphor formed on the lower layer close to the semiconductor layer. Therefore, there is a tendency that the phosphor formed on the lower layer has a great amount of emissions whereas the phosphor formed on the upper layer close to the upper surface, from which the light is likely to be extracted to the outside, has the less amount of emission.

The frequency of excitation of the phosphor 33 which is provided on the upper layer by the light radiated from the semiconductor layer 15 is less than the frequency of excitation of the phosphor 33 which is provided on the lower layer. Therefore, in the first transparent resin 31, a variation in the amount of emission of the phosphor 33 occurs in the thickness direction. In addition, the phosphor formed on the upper layer inhibits the light radiated from the phosphor formed on the lower layer from being extracted to the outside. This phenomenon becomes more remarkable as the phosphor concentration becomes higher.

In contrast, according to the embodiment, the optical layer 30 is provided with the first transparent portion 32a of the second transparent resin 32 not including the phosphor, the second transparent portion 32b, and the inclined portion 32s. Therefore, a portion of the light radiated from the phosphor 33 which is provided on the lower layer of the optical layer 30 is radiated to the outside via the first transparent portion 32a and the second transparent portion 32b. Accordingly, the extraction efficiency of the light radiated from the phosphor 33 which is provided on the lower layer of the optical layer 30 is improved.

In addition to the above description, a portion of the light radiated from the semiconductor layer 15 causes the phosphor 33 which is provided on the upper layer of the optical layer 30 to be excited via the first transparent portion 32a. For this reason, it is possible to realize a uniform amount of emission regardless of the position at which the phosphor 33 is provided.

In addition to the above description, an arrow in FIG. 3A and FIG. 3B illustrates a path of a portion of the light radiated from the semiconductor layer 15. The light, which is incident on the first transparent portion 32a from the light-emitting element 10 and travels in the Z direction, reaches the inclined portion 32s. The light is totally reflected from the inclined portion 32s so as to be radiated to the outside.

By changing an angle of the inclined portion 32s, it is possible to adjust an angle of the light radiated through the first transparent portion 32a. That is, it is possible to control the light distribution property of the light radiated from (for example, light having the blue wavelength corresponding to the blue light) the semiconductor layer 15, thereby reducing color break up (yellowing or the like).

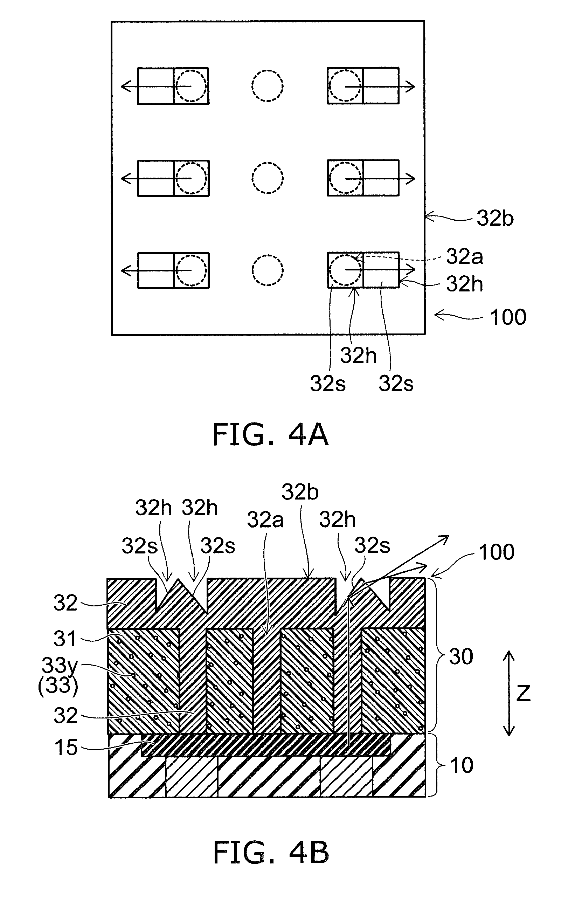

As shown in FIG. 4A and FIG 4B, the inclined portion 32s may be provided on, for example, the upper surface of the second transparent portion 32b above the first transparent resin 31. Another second inclined portion 32s is provided in the direction in which the light totally reflected from a first inclined portion 32s immediately above the first transparent portion 32a travels. As shown in an arrow in FIG. 4A and FIG. 4B, by properly setting an angle of inclination of the second inclined portion 32s, it is possible to reduce an incident angle of the light, which is totally reflected from the first inclined portion 32s, with respect to the second inclined portion 32s, thereby improving extraction efficiency of the light extracted to the air from the second transparent resin 32. In addition, it is possible to improve the extraction efficiency of the light and light distribution controllability by using a plurality of the inclined portions 32s which have different angles of inclination from one another.

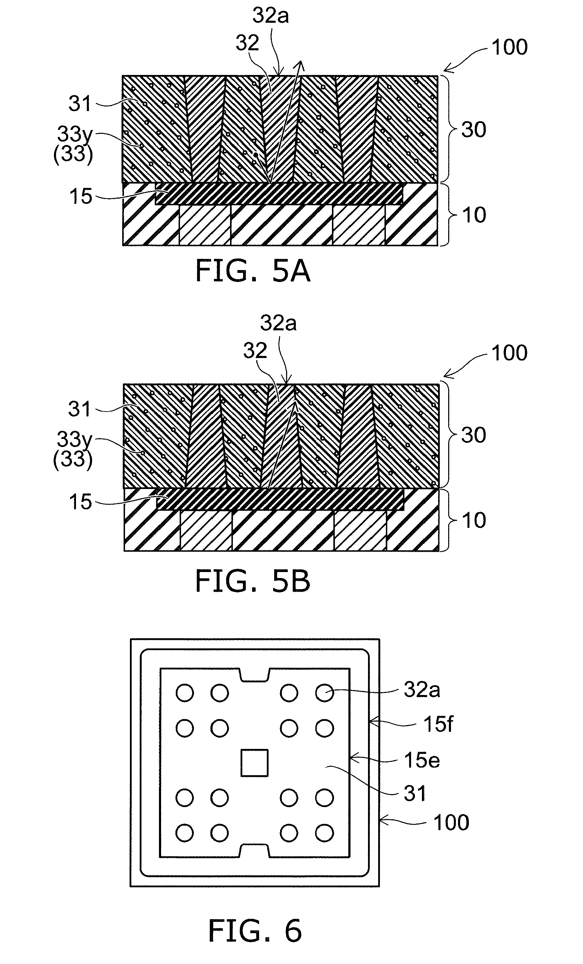

FIG. 5A and FIG 5B are cross-sectional views showing a shape of the first transparent portion 32a in the optical layer 30.

As shown in FIG. 5A, for example, the diameter of an upper end portion of the first transparent portion 32a is larger than the diameter of a lower end portion of the first transparent portion 32a. That is, a side wall of the first transparent portion 32a is provided in a so-called normal tapered shape. Therefore, as shown with the arrow in FIG. 5A, the light (a return fluorescent component) radiated in the direction from the phosphor 33 to the light-emitting element 10 is likely to be radiated to the outside via the first transparent portion 32a. That is, it is possible to improve the efficiency of extracting the light radiated from the phosphor 33 of the lower layer side to the outside.

As shown in FIG. 5B, for example, the diameter of the upper end portion of first transparent portion 32a is smaller than the diameter of the lower end portion of the first transparent portion 32a. That is, the side wall of the first transparent portion 32a is provided in a so called reverse tapered shape. Therefore, as shown with the arrow in FIG. 5B, the phosphor 33 which is provided at the upper end in the optical layer 30 is likely to be excited. That is, it is possible to improve the efficiency of extracting the light radiated from the phosphor 33 of the upper layer side to the outside.

FIG. 6 is a plan view schematically illustrating a main component of the semiconductor light-emitting device in the embodiment. As shown in FIG. 6, the semiconductor light-emitting device 100 is provided with the portion 15e including the light-emitting layer 13 (the p-side electrode 16) and the portion 15f not including the light-emitting layer 13 (the n-side electrode 17). The first transparent portion 32a is provided on the portion 15e including the light-emitting layer 13 (the p-side electrode 16) but is not provided on the portion 15f not including the light-emitting layer 13 (the n-side electrode 17) when viewed in the direction from the optical layer 30 to the light-emitting element 10. That is, the first transparent portion 32a is provided while perfectly overlapping with the light-emitting layer 13 but does not overlap at all with the area in which the light-emitting layer 13 is not formed.

For example, in a case where the first transparent portion 32a is provided on the portion 15f not including the light-emitting layer 13, the variation in the area in which the first transparent portion 32a overlaps with the portion 15f not including the light-emitting layer 13 is influential in the variation of the amount of the light radiated via the first transparent portion 32a.

In contrast, according to the embodiment, the first transparent portion 32a is provided on the portion 15e including the light-emitting layer 13 and does not overlap with the area in which the light-emitting layer 13 is not formed. Therefore, it is possible to suppress the variation of the light radiated via the first transparent portion 32a.

The refractive index of the first transparent resin 31 is lower than, for example, the refractive index of the second transparent resin 32. For this reason, the light radiated from the semiconductor layer 15 to the first transparent portion 32a is likely to be radiated from the second transparent portion 32b. In other words, the transmittance of the light guided to the first transparent portion 32a is increased. In addition, the light traveling from the first transparent resin 31 to the second transparent resin 32 is suppressed from being totally reflected. This condition is effective when the concentration of the phosphor 33 which is scattered in the first transparent resin 31 is high (a low color temperature).

The refractive index of the first transparent resin 31 is higher than, for example, the refractive index of the second transparent resin 32. At this time, the total reflection and the reflectance are suppressed in an interface between the first transparent resin 31 and the second transparent resin 32, and an interface between the second transparent resin 32 and the outside of the optical layer 30. Accordingly, the extraction efficiency of the light extracted to the air from the first transparent resin 31 via the second transparent resin 32 is improved. This condition is effective when the concentration of the phosphor 33 which is scattered in the first transparent resin 31 is low (a high color temperature).

According to the embodiment, it is possible to improve the extraction efficiency of the light and to provide a semiconductor light-emitting device excellent in chromaticity.

### (Second embodiment)

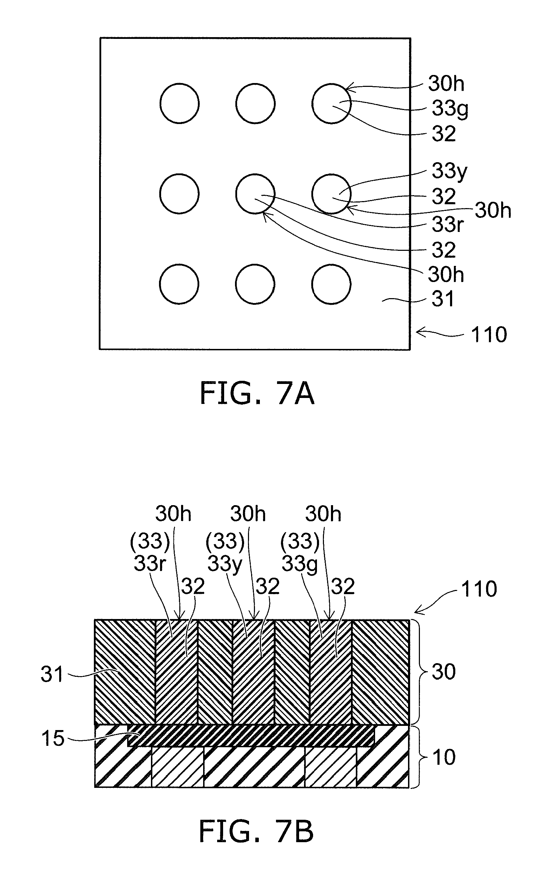

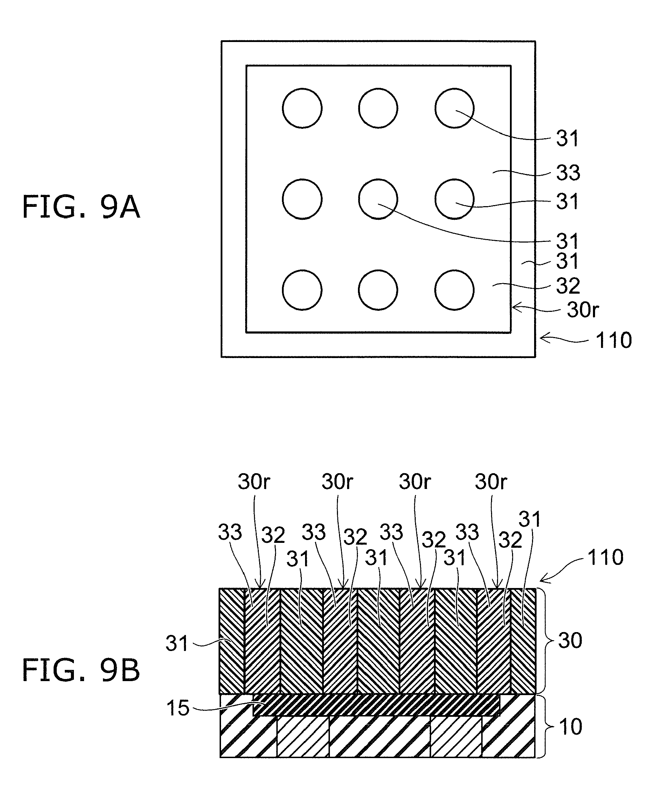

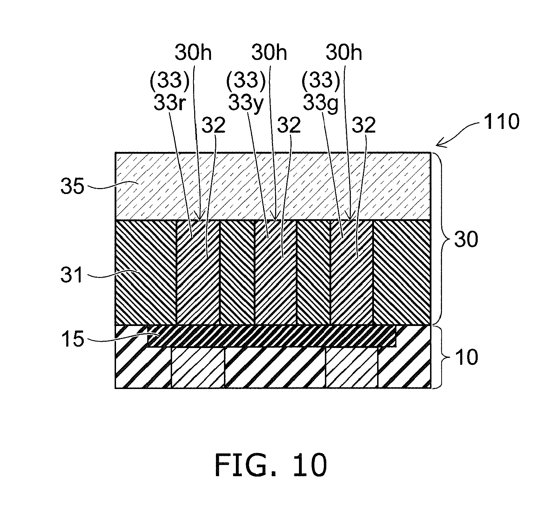

FIG. 7A to FIG. 13B are schematic views illustrating a semiconductor light-emitting device of the second embodiment.

FIG. 7A is a top view schematically illustrating a semiconductor light-emitting device 110 and FIG. 7B is a cross-sectional view schematically illustrating the semiconductor light-emitting device 110.

Similar to the first embodiment, also in the semiconductor light-emitting device 110 of the second embodiment, the optical layer 30 is provided on the light-emitting element 10 and the optical layer 30 includes the first transparent resin 31. In the embodiment, the optical layer 30 includes a phosphor layer 30h, 30r and the first transparent resin 31. One of the first transparent resin 31 or the phosphor layer 30h, 30r is pillar-shaped, the other surrounds the pillar-shaped first transparent resin 31 or the pillar-shaped phosphor layer 30h.

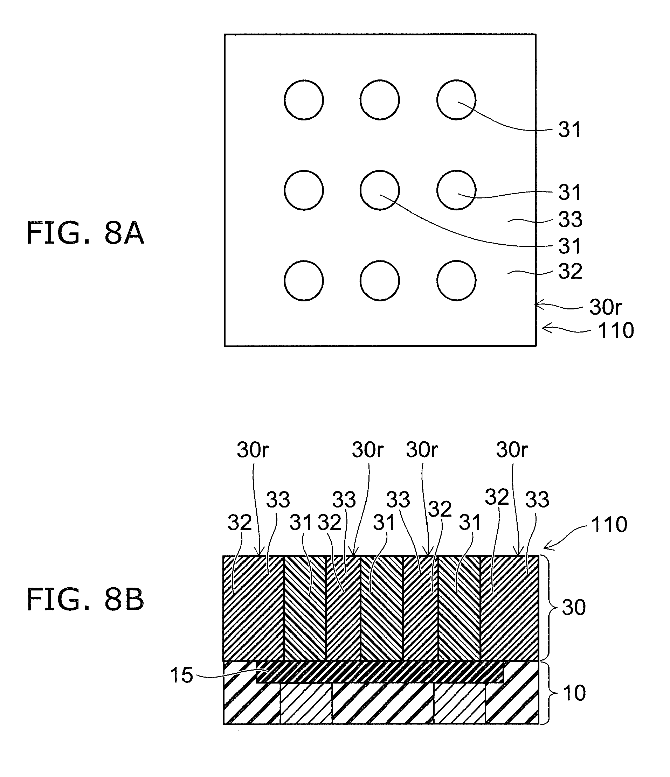

As shown in FIG. 7B, the phosphor layer 30h is pillar-shaped, and the first transparent resin 31 surrounds the pillar-shaped phosphor layer 30h. For example, as shown in FIG. 8A, the first transparent resin 31 is pillar-shaped, and the phosphor layer 30r surrounds the pillar-shaped first transparent resin 31.

For example, one of the pillar-shaped first transparent resin 31 or the pillar-shaped phosphor layer 30h is able to have a plurality of pillar portion. For example, as shown in FIG. 8B, the phosphor layer 30r surrounding the pillar-shaped first transparent resin 31 is surrounded by the first transparent resin 31.

The phosphor layer 30h includes the second transparent resin 32 and the plurality of particulate phosphors 33. The second transparent resin 32 is provided among the plurality of particulate phosphors 33. The phosphor 33 forms, for example, a pseudo-bulk (the pillar-shaped high concentration phosphor portion). At this time, it is possible to radiate the heat generated from the phosphor 33 to the light-emitting element 10 side without the second transparent resin 32. For this reason, the heat radiation property of the phosphor 33, which forms the pseudo-bulk formed of the high concentration phosphors 33 being contact with each other is more excellent than the heat radiation property of the normal phosphor 33 which is scattered in the transparent resin. That is, by providing the phosphor 33 as the pseudo-bulk, it is possible to reduce the thermal resistance of the optical layer 30, thereby suppressing the heat generation and temperature increase (heat dissipation) of the optical layer 30.

A total volume of the phosphors 33 included in the phosphor layer 30h is larger than a volume of the second transparent resin 32. The inside of the phosphor layer 30h is in a state where the plurality of particulate phosphors 33 are in contact with each other, for example, 80% or more of the particulate phosphors 33 are in contact with other particulate phosphors 33.

For example, X-ray CT is used as a measuring method of the total volume of the phosphors 33 and the volume of the second transparent resin 32. The X-ray CT can show the structure of the phosphor layer 30h three-dimensionally, and clearly shows the fluorescent particles contained in it. Thus, the average spacing between the phosphors contained in the phosphor layer 30h can be measured using the X-ray CT. That is, the average spacing can be found by tree-dimensionally measuring the position of the phosphors 33 by CT scanning and statistically processing the measurement data.

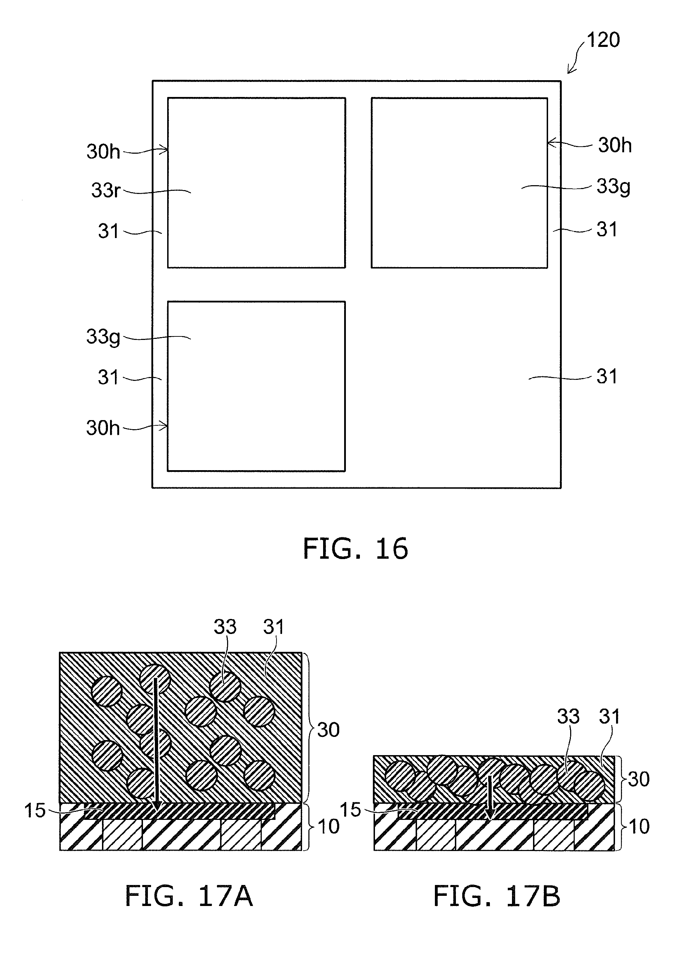

For example, as shown in FIG. 17B, the plurality of phosphors 33 which are in contact with each other are consecutive in the thickness direction of the optical layer 30. Therefore, it is possible to release the heat generated from the phosphor 33 in the upper layer of the optical layer 30 to the light-emitting element 10 without the transparent resin (in the arrow direction of FIG. 17B). Accordingly, it is possible to realize an excellent heat radiation property.

As shown in FIG. 7B, the heat generation of the optical layer 30 can be suppressed and the light extraction efficiency can be improved by providing the phosphor 33 as the pillar-shaped pseudo-bulk. Furthermore, the disposition of the phosphor 33 on the light-emitting element 10 can be easily controlled. Therefore, it is possible to reduce the variation in the chromaticity of the radiated light.

In the structure in which the phosphor layer is provided on the semiconductor layer including the light-emitting layer, generally, the excitation light (for example, blue light) from the light-emitting layer is more absorbed by the phosphor formed on the lower layer close to the semiconductor layer. Therefore, there is a tendency that the phosphor formed on the lower layer has the great amount of emission whereas the phosphor formed on the upper layer close to the upper surface, from which the light is likely to be extracted to the outside, has the less amount of emission.

The frequency of excitation of the phosphor 33 which is provided on the upper layer by the light radiated from the semiconductor layer 15 is less than the frequency of excitation of the phosphor 33 which is provided on the lower layer. Therefore, in the phosphor layer 30h, the variation in the amount of emission of the phosphor 33 occurs in the thickness direction. In addition, the phosphor formed on the upper layer inhibits the light radiated from the phosphor formed on the lower layer from being extracted to the outside. This phenomenon becomes more remarkable as the phosphor concentration becomes higher.

In contrast, according to the embodiment, the optical layer 30 is provided with the first transparent resin 31 not including the phosphor. Therefore, a portion of the light radiated from the phosphor 33 which is provided on the lower layer of the optical layer 30 is radiated to the outside via the first transparent resin 31. Accordingly, the extraction efficiency of the light radiated from the phosphor 33 which is provided on the lower layer of the optical layer 30 is improved. Furthermore, as shown in FIG. 8A, the light extraction efficiency can be improved by providing the pillar-shaped first transparent resin 31.

The side area of the phosphor layer 30r can be increased by providing one of the plurality of pillar-shaped first transparent resin 31 or the plurality of pillar-shaped phosphor layer 30h. Accordingly, the light can be easily extracted.

In addition to the above description, a portion of the light radiated from the semiconductor layer 15 causes the phosphor 33 which is provided on the upper layer of the optical layer 30 to be excited via the first transparent resin 31. For this reason, it is possible to realize the uniform amount of emission regardless of the position at which the phosphor 33 is provided.

As shown in FIG. 7A and FIG 7B, the plurality of phosphor layers 30h include the phosphors 33 (33r, 33g, 33y) which radiate light beams having different wavelengths from each other. The phosphor 33r (a first phosphor), which emits the light having the relatively greater wavelength (for example, the red light having the peak wavelength of about 610 nm to 660 nm), is provided on the phosphor layer 30h (a first phosphor portion) on the center portion side of the optical layer 30 in the plane direction (in the direction orthogonal with respect to the thickness direction).

In contrast, the phosphor 33g (a second phosphor), which emits the light having the wavelength (for example, the green light having the peak wavelength of about 500 nm to 600 nm) smaller than that of the first phosphor is provided on the phosphor layer 30h (a second phosphor portion) on the side surface side from the aforementioned center portion of the optical layer 30. Therefore, it is possible to reduce the reabsorption of the light radiated from the phosphor 33. That is, the extraction efficiency of the light radiated from the phosphor layer 30 his improved.

As shown in FIG. 8B, the phosphor layer 30r surrounding the pillar-shaped first transparent resin 31 (the pillar portion) is surrounded by the first transparent resin 31 (the cover portion). Accordingly, a volume variation of the phosphor 33 can be made small as compared with a volume variation of the phosphor layer 30r provided on a side of the semiconductor light-emitting device 110, the volume variation of the phosphor 33 is caused by forming the phosphor 33 such as dicing position displacement. Thus, the chromaticity variation can be suppressed, and the phosphor layer 30r can be protected.

FIG. 8C is a cross-sectional view schematically illustrating the semiconductor light-emitting device 110.

As shown in FIG. 8C, the optical layer 30 includes, for example, a light scattering layer 35. The light scattering layer 35 covers upper surfaces of the first transparent resin 31 and the phosphor layer 30h. The light scattering layer 35 is formed of the transparent resin which is transparent with respect to the radiated light from the semiconductor layer 15 and the radiated light from the phosphor 33, and scattering materials which are scattered in the transparent resin. The scattering material causes the radiated light from the semiconductor layer 15 and the radiated light from the phosphor 33 to be scattered.

The light scattered by the scattering material causes the phosphor 33 provided in the vicinity of the light scattering layer 35 to be efficiently excited. In addition, a scattering amount and the directivity of the light are controlled and thus it is possible to suppress the color break up. In addition to the above description, it is possible to adjust the chromaticity by performing the cutting (adjustment of the film thickness) of the light scattering layer 35. The cutting of the light scattering layer 35 is executed, for example, based on the measurement result of the wavelength of the light.

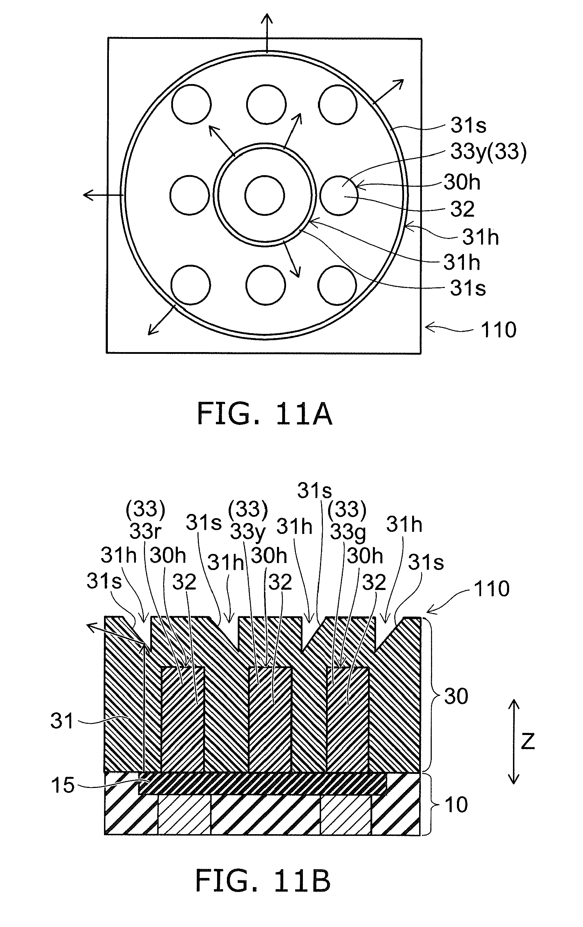

FIG. 11A is a top view schematically illustrating the semiconductor light-emitting device 110 and FIG. 11B is a cross-sectional view schematically illustrating the semiconductor light-emitting device 110.

As shown in FIG. 11B, the first transparent resin 31 is also provided on, for example, the phosphor layer 30h. An inclined portion 31s is provided on the layer upper than the phosphor layer 30h in the first transparent resin 31. The inclined portion 31s is inclined with respect to the first direction (the direction Z) orthogonal to the light-emitting layer 13. The inclined portion 31s is provided on the area between the phosphor layer 30h and the phosphor layer 30h.

The inclined portion 31s is provided on, for example, a void 31h which is formed in the first transparent resin 31. The inside of the void 31h is, for example, hollow. In the inside of the void 31h, a material having a refractive index lower than that of the first transparent resin 31 may be provided, for example.

The depth of the void 32h becomes greater toward the center portion side from the side surface side of the optical layer 30. The upper end of the inclined portion 32s is positioned at the side surface side of the optical layer 30 from the lower end of the inclined portion 32s. Therefore, as shown in an arrow in FIG. 11A and FIG. 11B, it is possible to cause the light which is radiated from the semiconductor layer 15 and travels the inside of the first transparent resin 31 between the phosphor layers 30h in the first direction (in the direction Z) to be totally reflected from the inclined portion 32s to the side surface side of the optical layer 30.

As shown in FIG. 11A, the inclined portion 31s consecutively surrounds the periphery of the phosphor layers 30h. Thus, it is possible to control the distribution property of the light radiated from the semiconductor layer 15.

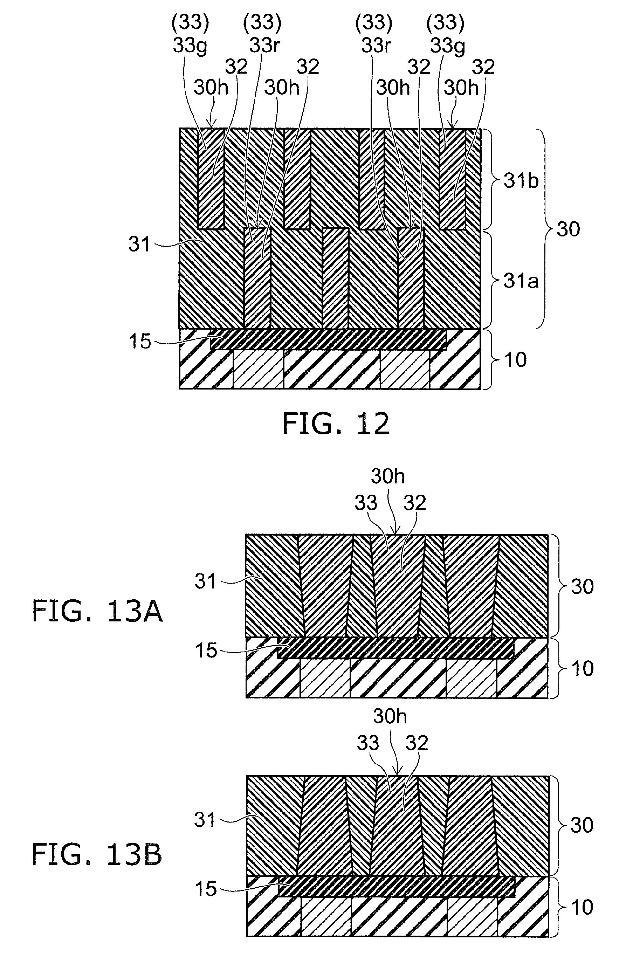

FIG. 12 is a cross-sectional view schematically illustrating the semiconductor light-emitting device 110.

As shown in FIG. 12, the first transparent resin 31 includes a lower layer portion 31a and an upper layer portion 31b. The phosphor layer 30h (the first phosphor layer) including the phosphor 33r is provided on the lower layer portion 31a. The phosphor layer 30h (the second phosphor layer) including the phosphor 33g is provided on the upper layer portion 31b. The phosphor 33g, which emits the light having the wavelength different from that of the phosphor 33r which is provided on the lower layer portion 31a is provided on the upper layer portion 31b. The phosphor 33r emits the red light and the phosphor 33g emits the green light having the small wavelength compared to the light of the phosphor 33r. The phosphor layer 30h of the upper layer portion 31b is provided so as not to overlap with the phosphor layer 30h of the lower layer portion 31a.

According to the semiconductor light-emitting device 110 in FIG. 12, it is possible to control an optical path of the light (blue light) passing through the first transparent resin 31, thereby reducing the color break up. In addition, it is possible to control the reabsorption of the light of the small wavelength radiated from the phosphor 33g, thereby improving the extraction efficiency of the light.

FIG. 13A and FIG. 13B are cross-sectional views illustrating a shape of the phosphor layer 30h in the optical layer 30.

As shown in FIG. 13A, for example, the side wall of the phosphor layer 30h is provided in the normal tapered shape. Therefore, the phosphor 33 which is provided on the upper end side of the optical layer 30 is likely to be excited. That is, it is possible to improve the efficiency of extracting the light radiated from the phosphor 33 of the upper layer side to the outside.

As shown in FIG. 13B, for example, the side wall of the phosphor layer 30h is provided in the reverse tapered shape. Therefore, the light which is radiated in the direction from the phosphor 33 to the light-emitting element 10 is likely to be radiated to the outside via the first transparent resin 31. That is, it is possible to improve the efficiency of extracting the light radiated from the phosphor 33 of the lower layer side to the outside.

According to the embodiment, similar to the first embodiment, it is possible to improve the extraction efficiency of the light and to provide the semiconductor light-emitting device excellent in chromaticity.

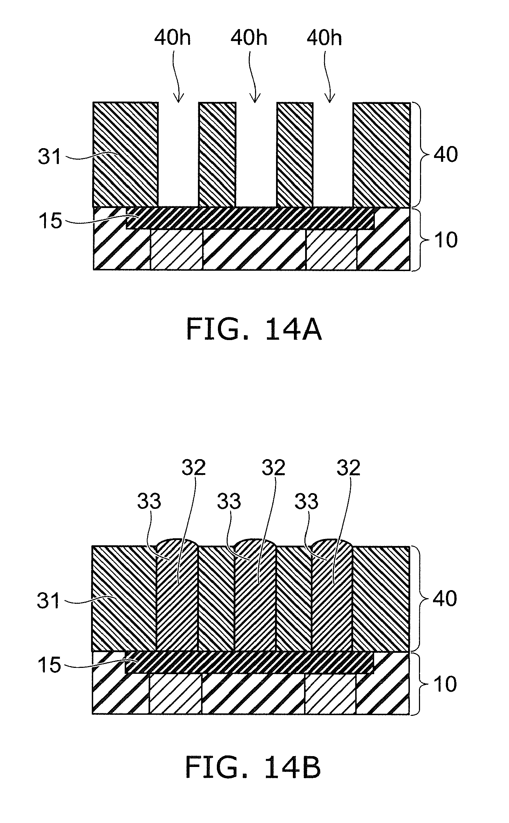

Next, the description is given of a method of manufacturing the semiconductor light-emitting device in the second embodiment with reference to FIG. 14A and FIG. 14B.

As shown in FIG. 14A, an optical member 40 is formed on the light-emitting element 10 in a wafer state before dicing. A pattern of a hole 40h is formed on the optical member 40. For example, it is possible to bond the sheet-like optical member 40 on which the hole pattern is formed onto the plurality of semiconductor layers 15. The optical member 40 may be formed, for example, on the plurality of semiconductor layers 15 by means of the imprinting method or the like.

The optical member 40 includes the first transparent resin 31 and a plurality of the holes 40h. The material which transmits the light radiated from the semiconductor layer 15 is used as the first transparent resin 31. Meanwhile, the transparent material, for example, glass or the like may be used as the first transparent resin 31. The hole 40h may not pass through the optical member 40 and the first transparent resin 31 may be formed on the bottom portion of the hole 40h.

Next, the wavelength of the light radiated from the plurality of semiconductor layers 15 is measured. At this time, the wavelength corresponding to, for example, the blue light is measured.

Thereafter, as shown in FIG. 14B, for example, the phosphor 33 is embedded in the hole 40h by means of an inkjet method. At this time, a type of the phosphor 33 which is embedded in the hole 40h is determined based on the measurement result of the wavelength of the light. For example, the phosphor 33r emitting red light, the phosphor 33y emitting yellow light, and the phosphor 33g emitting green light are used as the type of the phosphor 33. With this configuration, it is possible to adjust the color of the light radiated from the light-emitting element 10 via the optical member 40.

The second transparent resin 32 including, for example, the phosphor 33 may be embedded in the hole 40h, and a dilution solvent may be evaporated after embedding the dilution solvent including, for example, the phosphor 33 in the hole 40h.

Next, the phosphor 33 projecting from the upper surface of the optical layer 30 is ground and flattened. Therefore, the semiconductor light-emitting device 110 as shown in FIG. 7A and FIG 7B is formed.

Accordingly, it is possible to improve the extraction efficiency of the light and to provide the semiconductor light-emitting device excellent in chromaticity.

### Third embodiment

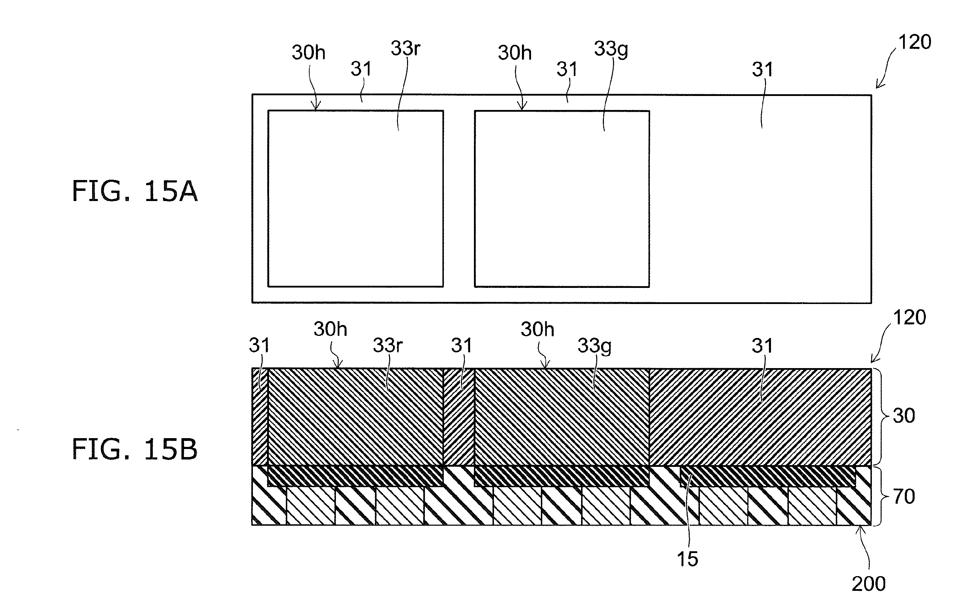

FIG. 15A to FIG. 16 are schematic views illustrating a semiconductor light-emitting device of a third embodiment.

FIG. 15A is a top view schematically illustrating a semiconductor light-emitting device 120 and FIG. 15B is a cross-sectional view schematically illustrating the semiconductor light-emitting device 120.

Similar to the aforementioned semiconductor light-emitting device 110, also in the semiconductor light-emitting device 120 of the third embodiment, the optical layer 30 is provided on the semiconductor layer 15 and the optical layer 30 includes the first transparent resin 31 and the phosphor layer 30h which is surrounded by the first transparent resin 31.

The phosphor 33 is provided in the phosphor layer 30h. The phosphor 33 is embedded in the first transparent resin 31 and the periphery thereof is surrounded by the first transparent resin 31 so as to form in the pseudo-bulk. The phosphor 33 may be formed in the phosphor layer 30h, for example, in a state of being included in the second transparent resin 32. At this time, similar to the embodiments described above, the total volume of the phosphors 33 is larger than the volume of the second transparent resin 32.

As shown in FIG. 15B, the phosphor layer 30h is provided on the semiconductor layer 15 and the phosphor layer 30h perfectly covers the area above the light-emitting layer 13.

In the embodiment, the semiconductor light-emitting device 120 includes a multichip package portion 70 including the plurality of semiconductor layers 15 and the support 200. For example, as shown in FIG. 15A and FIG. 15B, three semiconductor layers 15 are provided on the multichip package portion 70 and four semiconductor layers 15 are provided on the multichip package portion 70 as shown in FIG. 16.

As shown in FIG. 15A, the phosphor layer 30h (the first phosphor layer) including the phosphor 33r which emits the red light, the phosphor layer 30h (the second phosphor layer) including the phosphor 33g which emits the green light, and the first transparent resin 31 not including the phosphor are provided on each of the three semiconductor layers 15. The first transparent resin 31 is integrally provided except for portions where the phosphor layers 30h are provided on the multichip package portion 70. The color of the light radiated from the first transparent resin 31 is blue which is the same color as the light radiated from the semiconductor layer 15. For this reason, it is possible to allow the semiconductor light-emitting device 120 to optionally radiate the red light, the green light, and the blue light. That is, it is possible to utilize the semiconductor light-emitting device 120 as one pixel of a display.

As shown in FIG. 16, the phosphor layer 30h including the phosphor 33g is provided on two semiconductor layers 15 out of four semiconductor layers 15, and the phosphor layer 30h including the phosphor 33r and the first transparent resin 31 not including the phosphor are provided on other two semiconductor layers 15. According to the embodiment, the number of the semiconductor layers 15 of the multichip package portion 70 is optionally determined. Therefore, it is possible to improve a resolution by increasing the number of the semiconductor layers 15.

As shown in FIG. 17A, for example, the phosphor 33 is provided by being scattered in the first transparent resin 31 having a thick film. That is, the phosphor 33 is provided in a state of being low concentration. At this time, it is necessary to release the heat generated from the phosphor 33 in the upper layer of the optical layer 30 to the light-emitting element 10 via the first transparent resin 31 (in the arrow direction of FIG. 17A).

In the embodiment, the phosphor 33 is embedded in the phosphor layer 30h. At this time, as shown in FIG. 17B, the phosphor 33 is provided in the same state as a case where the phosphor 33 is provided by being scattered in the first transparent resin 31 having a thin film at high concentration. The plurality of phosphors 33 which are in contact with each other are consecutive in the thickness direction of the optical layer 30. Therefore, it is possible to release the heat generated from the phosphor 33 in the upper layer of the optical layer 30 to the light-emitting element 10 without the first transparent resin 31 (in the arrow direction of FIG. 17B). Accordingly, it is possible to realize excellent heat radiation property.

According to the embodiment, similar to the first and second embodiments described above, it is possible to improve the extraction efficiency of the light and to provide the semiconductor light-emitting device excellent in chromaticity. In addition to the above description, the heat radiation property of the optical layer 30 is improved and thus the semiconductor light-emitting device can be used for applications such as a large sized display requiring high luminance (high power).

Furthermore, the phosphor layer 30h is surrounded by the first transparent resin 31. Accordingly, a volume variation of the phosphor 33 can be made small as compared with a volume variation of the phosphor layer 30h provided on a side of the semiconductor light-emitting device 110, the volume variation of the phosphor 33 is caused by forming the phosphor 33 such as dicing position displacement. Thus, the chromaticity variation can be suppressed, and the phosphor layer 30h can be protected.

In the first to third embodiments described above, the optical layer 30 may include a plurality of particulate scattering materials (for example, titanium compound). In addition, the optical layer 30 may include the phosphor made of ceramic and a glass distribution phosphor. As the first transparent resin 31 and the second transparent resin 32, materials (for example, glass or the like) except for the resin transmitting the light radiated from the light-emitting layer 13 and the light radiated from the phosphor 33 may be used.

According to the aforementioned embodiments, in the semiconductor light-emitting device, for example, a plurality of the pillar-shaped first transparent portions are provided at an equal interval.

According to the aforementioned embodiments, in the semiconductor light-emitting device, for example, the width of the inclined portion in the second direction parallel with the light-emitting layer is larger than the diameter of the first transparent portion.

According to the aforementioned embodiments, in the semiconductor light-emitting device, for example, the inclined portion includes a plurality of inclined surfaces having different inclined angles from each other.

According to the aforementioned embodiments, in the semiconductor light-emitting device, for example, the refractive index of the first transparent body is higher than the refractive index of the second transparent body.

According to the aforementioned embodiments, in the semiconductor light-emitting device, for example, the refractive index of the first transparent body is lower than the refractive index of the second transparent body.

According to the aforementioned embodiments, in the semiconductor light-emitting device, for example, the diameter of the upper end portion of the first transparent portion is greater than the diameter of the lower end portion of the first transparent portion.

According to the aforementioned embodiments, in the semiconductor light-emitting device, for example, the diameter of the upper end portion of the first transparent portion is less than the diameter of the lower end portion of the first transparent portion.

According to the aforementioned embodiments, in the semiconductor light-emitting device, for example, the inclined portion is provided in the area between the plurality of phosphor layers.

According to the aforementioned embodiments, in the semiconductor light-emitting device, for example, the inclined portion consecutively surrounds the periphery of the plurality of phosphor layers.

According to the aforementioned embodiments, the semiconductor light-emitting device, for example, further includes the light scattering layer which is provided on the first transparent body and on the plurality of phosphor layers.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modification as would fall within the scope and spirit of the inventions.

## Claims

1. A semiconductor light-emitting device comprising:
a light-emitting element (10) including a light-emitting layer (13);
a first layer (31) provided on the light-emitting element (10) and having transparency;
a phosphor (33, 33r, 33g, 33y) scattered in the first layer (31) and emitting a light of a different wavelength from a radiated light of the light-emitting layer (13); and
a second layer (32) including a first portion (32a) and a second portion (32b), the first portion (32a) having transparency and surrounded by the first layer (31) on the light-emitting element (10), the second portion (32b) having transparency and provided on the first layer (31) and the first portion (32a),
the second portion (32b) including an inclined portion (32s) provided on the first portion (32a), the inclined portion (32s) inclined with respect to a first direction orthogonal to the light-emitting layer (13).

2. The device according to claim 1, wherein the first portion (32a) has a pillar shape.

3. The device according to claim 2, wherein a plurality of the pillar-shaped first portions (32a) is provided at an equal interval.

4. The device according to claim 2, wherein a width of the inclined portion (32s) in a second direction parallel with the light-emitting layer (13) is larger than a diameter of the first portion (32a).

5. The device according to claim 2, wherein a diameter of an upper end portion of the first portion (32a) is larger than a diameter of a lower end portion of the first portion (32a).

6. The device according to claim 2, wherein a diameter of an upper end portion of the first portion (32a) is smaller than a diameter of a lower end portion of the first portion (32a).

7. The device according to claim 1, wherein the first portion (32a) overlaps with the light-emitting layer (13) and does not overlap with an area in the light-emitting layer (13) being not present, as viewed in a direction from the second layer (32) to the light-emitting element (10).

8. The device according to claim 1, wherein a upper end of the inclined portion (32s) is provided on a side surface side of the second layer (32) from a lower end of the inclined portion (32s).

9. The device according to claim 1, wherein a refractive index of the first layer (31) is higher than a refractive index of the second layer (32).

10. The device according to claim 1, wherein a refractive index of the first layer (31) is lower than a refractive index of the second layer (32).

11. A semiconductor light-emitting device comprising:
a light-emitting element (10) including a light-emitting layer (13);
a first layer (31) provided on the light-emitting element (10) and having transparency; and
a phosphor layer (30h, 30r) including a plurality of phosphors (33, 33r, 33g, 33y) and a second layer (32), the plurality of phosphors (33, 33r, 33g, 33y) provided on the light-emitting element (10), and emitting a light of a different wavelength from a radiated light of the light-emitting layer (13), the second layer (32) provided among the plurality of phosphors (33, 33r, 33g, 33y) and having transparency,
one of the first layer (31) or the phosphor layer (30h, 30r) being pillar-shaped, the other surrounding the pillar-shaped first layer (31) or the pillar-shaped phosphor layer (30h),
a total volume of the plurality of phosphors (33, 33r, 33g, 33y) of the phosphor layer (30h, 30r) being larger than a volume of the second layer (32) of the phosphor layer (30h, 30r).

12. The device according to claim 11, wherein the phosphor layer (30h) includes:
a first phosphor portion (30h) including a first phosphor (33, 33r); and
a second phosphor portion (30h) including a second phosphor (33, 33g) emitting a light of a different wavelength from a light emitted the first phosphor (33, 33r).

13. The device according to claim 12, wherein
the second phosphor (33, 33g) emits the light having a short wavelength being shorter than the wavelength of the light of the first phosphor (33, 33r), and
the second phosphor portion (30h) is provided on a side surface side of the first layer (31) from the first phosphor layer (30h).

14. The device according to claim 11, wherein the first layer (31) is provided on the phosphor layer (30h).

15. The device according to claim 14, further comprising:
an inclined portion (32s) inclined with respect to a first direction orthogonal to the light-emitting layer (13), the inclined portion (32s) provided on an upper layer from the phosphor layer in the first layer (31).

16. The device according to claim 11, wherein one of the pillar-shaped first layer (31) or the pillar-shaped phosphor layer (30h) being pillar-shaped having a plurality of pillar portions.

17. The device according to claim 16, further comprising a cover portion (31), wherein
the pillar-shaped first layer (31) is pillar-shaped having a plurality of pillar portions,
the phosphor layer (30h) surrounds the plurality of pillar portions,
the cover portion (31) surrounds the plurality of pillar portions and the phosphor layer (30h).

18. The device according to claim 11, wherein the phosphor layer includes(30h);
a first phosphor portion (30h) provided on a lower layer portion of the first layer (31) and including a first phosphor (33, 33r); and
a second phosphor portion (30h) provided on an upper layer portion of the first layer (31) so as not to overlap with the first phosphor portion (30h) and including a second phosphor (33, 33g) emitting a light having a short wavelength being shorter than a wavelength of a light of the first phosphor (33, 33r).

19. A semiconductor light-emitting device comprising:
a multichip package portion (70) including a plurality of semiconductor layers (15) and a support (200), each of the plurality of semiconductor layers (15) including a light-emitting layer (13) and separated from each other, the support (200) integrally supporting the plurality of semiconductor layers (15);
a first layer (31) provided on the multichip package portion (70) and having transparency;
a first phosphor layer (30h) provided on at least one of the plurality of semiconductor layers (15), surrounded by the first layer (31), and including a first phosphor (33, 33r) and a second layer (32), the second layer (32) provided among the first phosphor (33, 33r); and
a second phosphor layer (30h) provided on at least one of the plurality of semiconductor layers (15), surrounded by the first layer (31), and including a second phosphor (33, 33g) and the second layer (32), the second layer (32) provided among the first phosphor (33, 33r), the second phosphor (33, 33g) emitting a light of a different wavelength from a light of the first phosphor (33, 33r),
a volume of the first phosphor (33, 33r) of the first phosphor layer (30h) being larger than a volume of the second layer (32) of the first phosphor layer (30h),
a volume of the second phosphor (33, 33g) of the second phosphor layer (30h) being larger than a volume of the second layer (32) of the second phosphor layer (30h),
the first layer (31) provided, without providing a phosphor (33, 33r, 33g, 33y), on at least one of the plurality of semiconductor layers (15).

20. The device according to claim 19, wherein
a peak wavelength of the light radiated from the plurality of semiconductor layers (15) is not less than 360 nm nor more than 470 nm,
a peak wavelength of the light radiated from the first phosphor (33, 33r) is not less than 610 nm nor more than 660 nm, and
a peak wavelength of the light radiated from the second phosphor (33, 33g) is not less than 500 nm nor more than 600 nm.
